# EUROPEAN PATENT SPECIFICATION

(11) **EP 3 944 306 B1**
(45) Date of publication and mention of the grant of the patent: **06.08.2025**
(21) Application number: 20778938.9
(22) Date of filing: 19.03.2020
(51) Int. Cl.: H01L 23/467, H01L 23/473, H05K 7/20, F28F 21/06, F28F 3/02

(54) **COOLING STRUCTURE**
KÜHLSTRUKTUR
STRUCTURE DE REFROIDISSEMENT

(30) Priority: 22.03.2019 JP 2019055691
(43) Date of publication of application: 26.01.2022
(73) Proprietor: Resonac Corporation, Tokyo 105-7325 (JP)
(72) Inventor: SHOUDA, Hiroaki, Tagawa-shi, Fukuoka 825-0005 (JP); YAMASHITA, Takahiro, Tagawa-shi, Fukuoka 825-0005 (JP); FUJISAWA, Kazutake, Tagawa-shi, Fukuoka 825-0005 (JP)
(74) Representative: Hoffmann Eitle
(86) International application number: PCT/JP2020/012482
(87) International publication number: WO 2020/196330

(56) References cited:
- WO-A1-2016/080333
- JP-A- 2003 003 248
- JP-A- 2008 075 896
- JP-A- 2012 015 240
- JP-A- 2012 015 240
- JP-A- 2015 073 100
- JP-A- 2017 017 073
- JP-A- 2017 161 204

## Description

### Technical Field

The present disclosure relates to a cooling structure.

### Background Art

A vehicle equipped with a motor, such as a hybrid car or an electric car is equipped with a driving means that drives the motor. The driving means includes electronic components such as a power module including a plurality of power semiconductors such as an insulated gate bipolar transistor (IGBT), and a capacitor, and a bus bar electrically joining these electronic components.

When the motor is driven, a large current may flow through the power semiconductor, the capacitor, and the bus bar joining these electronic components. In this case, the driving means generates heat due to switching loss, resistance loss, or the like, and therefore needs to be cooled efficiently.

As a cooling means for cooling the driving means, a heat sink including a metal such as aluminum or copper is used because of its high thermal conductivity (see, for example, Patent Literature 1).

### Citation List

### Patent Literature

Patent Literature 1: Japanese Patent Application Laid-Open (JP-A) No. 2010-182831

### SUMMARY OF INVENTION

### Technical Problem

However, in order to manufacture a metal heat sink, it is necessary to perform complicated manufacturing processes such as extrusion molding, skiving, and caulking. Thus, the metal heat sink tends to be expensive.

In addition, many man-hours may be required to incorporate a metal heat sink into a cooling target such as a driving means. Therefore, there is a demand for a resin cooling means that is easy to process and easy to incorporate into a driving means or the like.

On the other hand, the resin cooling means, which generally has lower strength than the metal heat sink, is required to have high strength.

An aspect of the present disclosure has been made in view of the above conventional circumstances, and an object of the present disclosure is to provide a cooling structure made of resin and having excellent cooling efficiency and high strength.
JP 2015/073100 A discloses features falling under the preamble of claim 1.

### Solution to Problem

The invention is defined by claim 1.

### Advantageous Effects of Invention

An aspect of the present disclosure can provide a cooling structure made of resin and having excellent cooling efficiency and high strength.

### BRIEF DESCRIPTION OF DRAWINGS

Fig. 1 is a sectional view illustrating a main part of a cooling structure 10 according to a first embodiment.
Fig. 2 is a diagram illustrating an example of a region in which cooling fins 24 are provided in a cooling structure 10.
Fig. 3 is a diagram illustrating another example of the region in which the cooling fins 24 are provided in the cooling structure 10.
Fig. 4 is an end view illustrating a main part of a cooling structure 11 according to a second embodiment.
Fig. 5 is an end view illustrating a main part of a cooling structure 38 according to a third embodiment.
Fig. 6 is a sectional view illustrating a main part of a cooling structure 44 according to a fourth embodiment.
Fig. 7 is a diagram illustrating evaluation results of magnetic field shielding performance of a metal layer.
Fig. 8 is a diagram for describing a method of evaluating cooling performance.

### DESCRIPTION OF EMBODIMENTS

### <Cooling Structure>

A cooling structure according to the disclosure includes a flow path configuration member made of resin and forming a flow path through which a refrigerant flows; and a cooling fin extending from an inner wall of the flow path toward an inside of the flow path, having a distal end that is in contact with the inner wall, and having a surface made of resin. The cooling structure according to the disclosure has excellent cooling efficiency and high strength.

Hereinafter, the cooling structure of the disclosure will be described with reference to the drawings. Note that sizes of members in the drawings are conceptual, and a relative relationship between the sizes of the members is not limited to the relationship disclosed herein. In addition, members having substantially the same functions are denoted by the same reference signs throughout the drawings, and redundant description may be omitted.

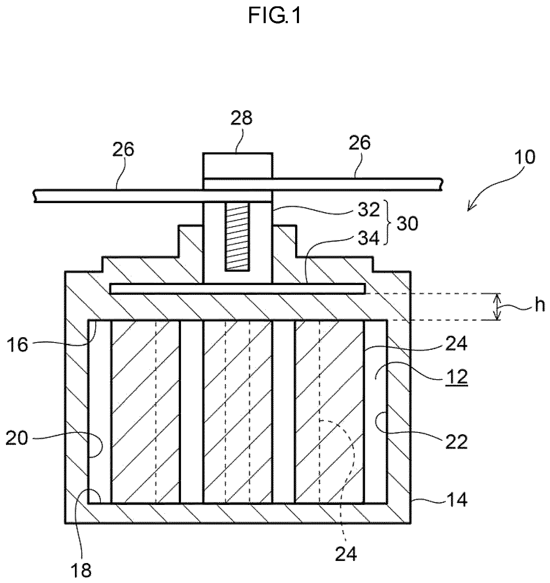

Fig. 1 is a sectional view illustrating a main part of a cooling structure 10 according to a first embodiment.

In the cooling structure 10, the cooling fin is provided in a region where the inner wall of the flow path has a substantially rectangular shape when a cross section of the flow path orthogonal to a direction in which the refrigerant flows is observed. The cooling fin extends from one inner wall toward another inner wall of a pair of opposing inner walls of the inner wall having a substantially rectangular shape, and the cooling fin is in contact with the other inner wall.

Note that, in the disclosure, a sectional shape of the flow path at a portion of the cooling structure in which the cooling fin is provided is not limited, and may be a substantially rectangular shape, or may be a shape other than a substantially rectangular shape, such as a circular shape, an elliptical shape, or a polygonal shape other than a rectangular shape.

Further, in the disclosure, the sectional shape of the flow path other than the portion of the cooling structure in which the cooling fin is provided is not limited.

The cooling structure 10 illustrated in Fig. 1 includes a flow path configuration member 14 made of resin and forming a flow path 12 that circulates a refrigerant and has a substantially rectangular cross section. The flow path 12 is surrounded by an upper inner wall 16 corresponding to an inner wall of one of a pair of opposing inner walls, a lower inner wall 18 corresponding to an inner wall of the other one of the pair of opposing inner walls, and a side inner wall 20 and a side inner wall 22 that connect the upper inner wall 16 and the lower inner wall 18.

Cooling fins 24 having a cylindrical shape and being in contact with a lower inner wall 18 extend from an upper inner wall 16 toward the lower inner wall 18. Similarly to the flow path configuration member 14, the cooling fins 24 is made of resin. In Fig. 1, a part of each cooling fin 24 is indicated by dotted lines.

Extending directions of a plurality of the cooling fins 24 are substantially parallel to each other. Since the extending directions of the plurality of cooling fins 24 are substantially parallel, when the flow path configuration member 14 including the cooling fins 24 is manufactured with use of a mold, the cooling fins 24 can be easily pulled out from the mold. It is therefore easy to manufacture the flow path configuration member 14 including the cooling fin 24 with use of a mold.

A bus bar 26 as a cooling target is fixed to a root of the cooling fins 24 with a bolt 28 and a nut 30. The nut 30 includes a nut body 32 and the heat diffuser 34 provided on a side of the nut body 32 opposite to a side into which the bolt 28 is inserted. The heat diffuser 34 has a quadrangular plate shape and is integrated with the nut body 32.

The bus bar 26 is connected to electronic components (not illustrated) such as a power semiconductor and a capacitor.

The entire heat diffuser 34 of the nut 30 and a part of the nut body 32 opposite to the side where the bolt 28 is inserted are embedded in the flow path configuration member 14. The heat diffuser 34 is not limited to be embedded in the flow path configuration member 14, and may be joined to the flow path configuration member 14, for example, may be joined to an outer wall of the flow path configuration member 14. For example, the heat diffuser 34 may be joined to the flow path configuration member 14 by a resin metal joining technique by laser roughening.

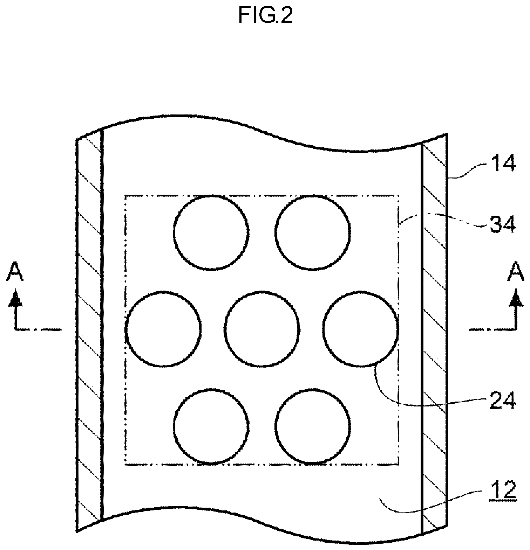

Fig. 2 is a diagram of a region in which the cooling fins 24 is provided in the cooling structure 10 illustrated in Fig. 1, as viewed from an insertion direction of the bolt 28. In order to facilitate understanding of a positional relationship between the cooling fins 24 and the heat diffuser 34, the bus bar 26 and the like are omitted in Fig. 2. In order to facilitate understanding of the positional relationship between the cooling fins 24 and the heat diffuser 34, the heat diffuser 34 is indicated by a two-dot chain line. Fig. 1 is a sectional view taken along line AA illustrated in Fig. 2.

As illustrated in Fig. 2, the number of cooling fins 24 is seven, and the cooling fins 24 are provided in a range where the heat diffuser 34 is disposed.

Here, when a current flows through the bus bar 26, the bus bar 26 itself generates heat due to a resistance loss. The bus bar 26 is connected to the electronic components (not illustrated), and heat generated from the electronic components by energization is diffused through the bus bar 26. The bus bar 26 is therefore likely to have high temperature.

The heat generated from the bus bar 26 itself and the heat diffused through the bus bar 26 are transferred to a portion integrated with the nut body of the heat diffuser 34 via the bolt 28 and the nut body 32. Since the heat diffuser 34 has a quadrangular plate shape, the heat transferred to the heat diffuser 34 is diffused in the plane direction of the heat diffuser 34 and can be diffused in a wide range.

The heat diffuser 34 is disposed at a root of the cooling fins 24, and the heat diffused to the heat diffuser 34 reaches the root of the cooling fins 24. The heat reaching the root of the cooling fins 24 moves from the root of the cooling fins 24 toward the lower inner wall 18 through the cooling fins 24. At this time, the heat is transferred from the cooling fins 24 to the refrigerant by the refrigerant flowing through the flow path 12. The cooling target such as the bus bar 26 is cooled in this way.

In the cooling structure 10, the cooling fins 24 extends from the upper inner wall 16 toward the lower inner wall 18, and the cooling fins 24 are in contact with the lower inner wall 18. For example, when the cooling fins 24 do not reach the lower inner wall 18, the refrigerant flowing between the distal ends of the cooling fins 24 and the lower inner wall 18 passes without contacting the cooling fin 24. The refrigerant passing without contacting the cooling fins 24 does not contribute to cooling of the cooling fins 24. As compared with a case in which the distal ends of the cooling fins 24 are not in contact with the lower inner wall 18, an amount of the refrigerant not in contact with the cooling fins 24 can be reduced in the cooling structure 10. Thus, the cooling efficiency of the cooling structure 10 is high. In addition, since the cooling fins 24 are in contact with the lower inner wall 18, particularly, when a load is applied from the upper inner wall 16 toward the lower inner wall 18 (or from the lower inner wall 18 toward the upper inner wall 16), a strength of the cooling structure 10 can be increased.

In Fig. 1, when the portion of the flow path 12 in which the cooling fins 24 are provided is observed from a direction in which the refrigerant flows, an area of the observed part of the cooling fins 24 in an area of the flow path 12 is preferably 30% or more, more preferably 70% or more, in terms of improving the cooling efficiency.

In Fig. 1, a minimum distance h from a surface of the heat diffuser 34 on a side of the flow path 12 to the inner wall of the flow path configuration member 14 is preferably 0.3 mm or more in terms of insulating properties, and more preferably 0.5 mm or more and still more preferably 1.5 mm or more in terms of moldability. The minimum distance h is preferably 2.5 mm or less in terms of the cooling efficiency.

At least a surface of the cooling fins 24 needs to be made of resin, and the entire cooling fins 24 may be made of resin, or the cooling fins 24 may have a metal rod-shaped core material. When the cooling fin 24 includes a rod-shaped core material, an entire surface of the metal core material is preferably covered with resin in terms of suppressing corrosion and the like. One end of the core material may be connected to the heat diffuser 34 in terms of improving the cooling efficiency.

In Fig. 1, the distal ends of the cooling fins 24 have a flat shape orthogonal to an extending direction of the cooling fins 24, but a shape of the distal ends of the cooling fins 24 is not limited, and may be hemispherical, conical, pyramidal, or the like.

Examples of the cooling target include electronic components such as a power semiconductor and a capacitor in addition to the bus bar 26. In a case in which the cooling target is an electronic component, the cooling fins may be provided at a portion where the electronic component is disposed in the cooling structure.

A positional relationship between the cooling fins 24 and the heat diffuser 34 in the cooling structure 10 is not limited.

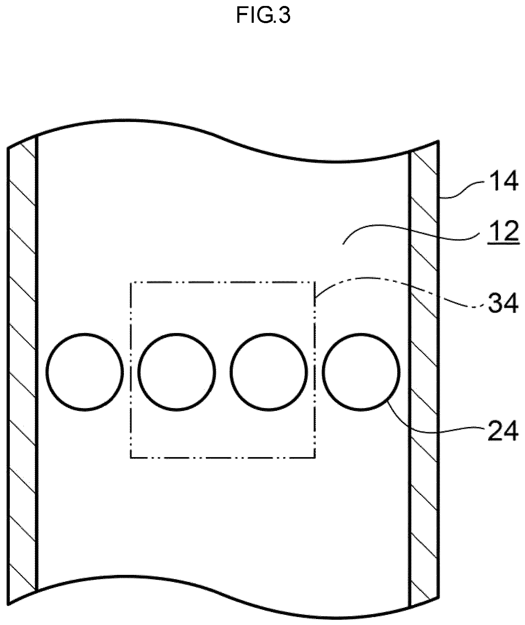

For example, as shown in Fig. 3, the cooling fins 24 may be disposed along a direction orthogonal to a direction in which the refrigerant flows in the flow path 12. The cooling fins 24 may be disposed at a position away from a region in which the heat diffuser 34 is disposed.

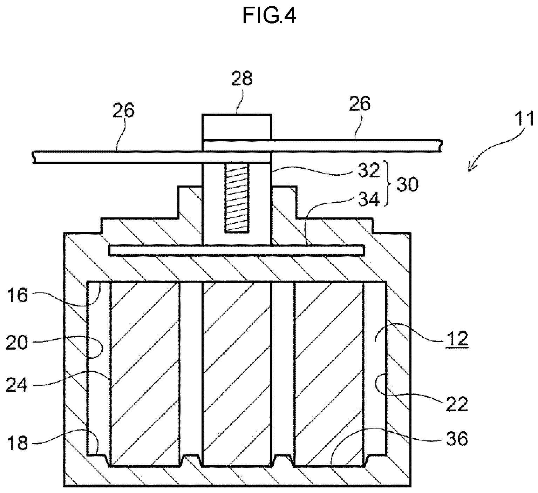

Fig. 4 is an end view illustrating a main part of a cooling structure 11 according to a second embodiment.

In the cooling structure 11 illustrated in Fig. 4, a recess 36 having a concave shape is provided in a portion of the lower inner wall 18 in contact with each cooling fin 24. The distal end of each cooling fin 24 is fitted in the recess 36. The distal end of each cooling fin 24 is fitted in the recess 36, and this increases a strength of the cooling fins 24 when a load is applied to the cooling fins 24 in the direction in which the refrigerant flows. Therefore, a flow rate of the refrigerant can be increased, and the cooling efficiency can be further improved.

In Fig. 4, the distal end of each cooling fin 24 has a flat shape orthogonal to the extending direction of the cooling fins 24, and a bottom surface of the recess 36 is parallel to the lower inner wall 18. For example, in a case in which the distal end of each cooling fin 24 has a hemispherical shape, the recess 36 may have a concave shape having a radius of curvature larger than a radius of curvature of the distal end of each cooling fin 24.

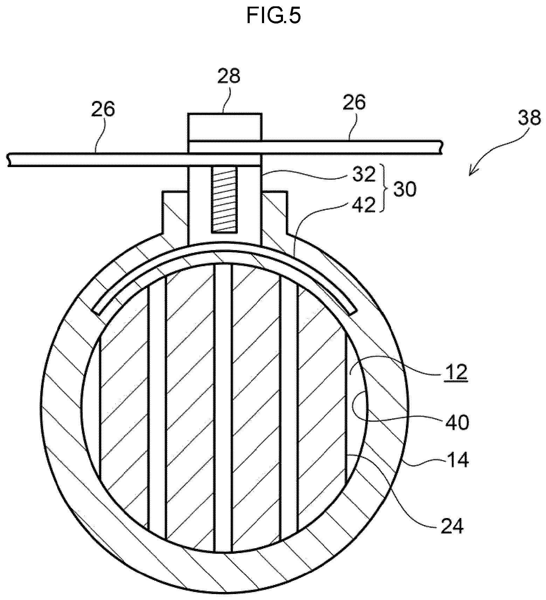

Fig. 5 is an end view illustrating a main part of a cooling structure 38 according to a third embodiment.

In the cooling structure 38 according to the third embodiment, the cooling fins are provided in a region where the inner wall of the flow path has a circular shape when a cross section orthogonal to the direction in which the refrigerant flows in the flow path is observed. The cooling fins extend from the circular inner wall toward the inside of the flow path, and the distal ends of the cooling fins are in contact with the inner wall.

The cooling structure 38 illustrated in Fig. 5 includes a flow path configuration member 14 made of resin and forming a flow path 12 that circulates a refrigerant and has a circular cross section.

The cooling fins 24 extend from an upper part of a cylindrical inner wall 40 constituting the flow path 12 in the drawing toward the inside of the flow path 12, and the distal ends of the cooling fins 24 are in contact with a lower part of the inner wall 40 in the drawing.

A bus bar 26 as a cooling target is fixed to a root of the cooling fins 24 with a bolt 28 and a nut 30. The nut 30 includes a nut body 32 and a heat diffuser 42 provided on a side of the nut body 32 opposite to a side into which the bolt 28 is inserted. Unlike the heat diffuser 34 illustrated in Fig. 1, the heat diffuser 42 is curved along the shape of the cylindrical inner wall 40 and is integrated with the nut body 32.

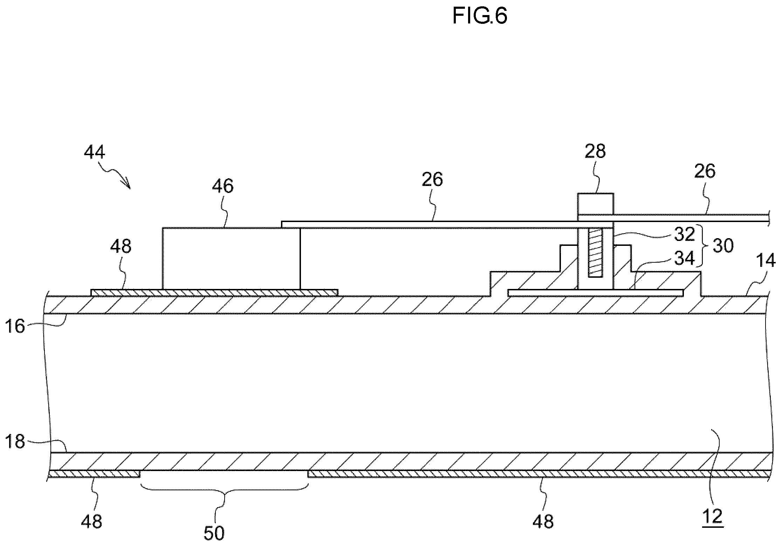

Fig. 6 is a sectional view illustrating a main part of a cooling structure 44 according to a fourth embodiment. Fig. 6 illustrates a cross section of a cooling structure 44, parallel to a direction in which the refrigerant flows through the flow path configuration member 14. In Fig. 6, the description of the cooling fin is omitted.

In the cooling structure 44 illustrated in Fig. 6, a power semiconductor 46 as a cooling target is in contact with the flow path configuration member 14 with the metal layer 48 provided on the outer wall of the flow path configuration member 14 interposed therebetween. A bus bar 26 is connected to the power semiconductor 46 to ensure conduction with other power semiconductors (not illustrated), other electric components, and the like. The cooling fins (not illustrated) extend from the upper inner wall 16 toward the lower inner wall 18 at a portion where the flow path configuration member 14 is in contact with the power semiconductor 46. That is, the power semiconductor 46 is disposed at the root of the cooling fins (not illustrated).

Heat generated from the power semiconductor 46 reaches the outer wall of the flow path configuration member 14 via the metal layer 48, and further, the heat reaching the root of the cooling fins (not illustrated) moves from the root of the cooling fins toward the lower inner wall 18 through the cooling fins. At this time, the heat is transferred from the cooling fins to the refrigerant by the refrigerant flowing through the flow path 12. Since the power semiconductor 46 is in contact with the flow path configuration member 14 with the metal layer 48 interposed therebetween, the heat generated from the power semiconductor 46 is likely to efficiently move to the cooling fins, and the cooling efficiency is improved.

In addition, the metal layer 48 can shield a magnetic field in a low frequency range (in particular, a radio band) generated from the power semiconductor 46. It is therefore effective to provide the metal layer 48 on the outer wall of the flow path configuration member 14 in terms of magnetic field shielding. The metal layer 48 only has to be provided on at least a part of the outer wall of the flow path configuration member 14. Note that, the metal layer 48, which is conductive, does not have to be provided at a portion where insulating properties are required. In addition, the metal layer 48 may be formed on the outer wall of the flow path configuration member 14, and the portion where insulating properties are required may be covered with a resin layer.

The metal layer 48 is preferably provided, for example, on the outer wall of the flow path configuration member 14 opposite to a side on which the cooling target is disposed. Further, as shown in Fig. 6, when the metal layer 48 is provided on a part of the outer wall of the flow path configuration member 14 on the side where the cooling target is disposed, a region 50 where the metal layer 48 is not provided may exist on the outer wall of the flow path configuration member 14 opposite to the side on which the cooling target is disposed. Further, a region where the metal layer 48 is not provided may exist on the outer wall opposite to a portion where the heat diffuser 34 in Fig. 6 is disposed.

A method of manufacturing the cooling structure according to the disclosure is not limited, and it is possible to adopt a usual method of molding a resin molded body such as an injection molding method, a die slide injection molding method, a blow molding method, a compression molding method, a transfer molding method, an extrusion molding method, or a cast molding method. Note that the die slide injection molding method is preferable because high positional accuracy may be required for manufacturing the cooling structure.

A portion of the nut embedded in the flow path configuration member may be separately manufactured by an insert molding method.

The types of the resins configuring the flow path configuration member and the cooling fin are not limited. Examples of the resin include a polyethylene-based resin, a polypropylene-based resin (PP), a composite polypropylene-based resin (PPC), a polyphenylene sulfide-based resin (PPS), a polyphthalamide-based resin (PPA), a polybutylene terephthalate-based resin (PBT), an epoxy-based resin, a phenol-based resin, polystyrene-based resin, a polyethylene terephthalate-based resin, a polyvinyl alcohol-based resin, a vinyl chloride-based resin, an ionomer-based resin, a polyamide-based resin, an acrylonitrile-butadiene-styrene copolymer resin (ABS), and a polycarbonate-based resin. The resins configuring the flow path configuration member and the resin configuring the cooling fin may be the same or different.

The resins configuring the flow path configuration member and the cooling fin may contain an inorganic filler. Examples of the inorganic filler include silica, alumina, zircon, magnesium oxide, calcium silicate, calcium carbonate, potassium titanate, silicon carbide, silicon nitride, boron nitride, beryllia, and zirconia. Furthermore, examples of the inorganic filler having a flame retardant effect include aluminum hydroxide and zinc borate.

The inorganic fillers included in the resins configuring the flow path configuration member and the cooling fin may be the same or different. One of the resins configuring the flow path configuration member or the resin configuring the cooling fin may include an inorganic filler, and the other does not have to include an inorganic filler.

Examples of the metal configuring the heat diffuser include metals such as aluminum, iron, copper, gold, silver, and stainless steel, and alloys thereof.

The heat diffuser may have a mesh shape, a punching metal, or the like in terms of suppressing a load on the cooling structure due to a difference in thermal expansion coefficient between the resins configuring the flow path configuration member and the cooling fin and the metal configuring the heat diffuser.

In the cooling structure, in terms of the heat diffusibility of the heat diffuser in the plane direction and heat dissipation of the cooling fin, the metal configuring the heat diffuser is preferably at least one selected from the group consisting of aluminum, iron, copper, gold, silver, and stainless steel, and the resin configuring the cooling fin is preferably at least one selected from the group consisting of a polyphenylene sulfide-based resin, a polyamide-based resin, a polyphthalamide-based resin, a polybutylene terephthalate-based resin, a phenol-based resin, and an epoxy-based resin. Preferable examples of the polyamide-based resin include nylon 6 and nylon 66.

The type of the refrigerant flowing through the flow path is not limited. Examples of the refrigerant include a liquid such as water and an organic solvent, and a gas such as air. The water used as the refrigerant may include a component such as an antifreeze liquid.

The component configuring the metal layer 48 is not limited, and examples thereof include zinc, aluminum, a zinc-aluminum alloy, carbon steel, stainless steel, nickel, a nickel alloy, tin, copper, a copper alloy, silver, a silver alloy, gold, a gold alloy, and molybdenum. Among these components, silver and copper are preferable in terms of enhancing a magnetic field shielding effect. On the other hand, silver and gold are preferable in terms of the cooling efficiency.

A method of forming the metal layer 48 is not limited, and examples thereof include electrolytic plating, electroless plating, vapor deposition, attachment of a metal plate, and metal spraying. The metal layer 48 is preferably a sprayed metal layer formed by a metal thermal spraying method in terms of formability, and is more preferably zinc in terms of workability.

A thickness of the metal layer 48 is not limited, and is preferably from 1 µm to 2 mm.

An average thickness of the metal layer 48 in contact with the power semiconductor 46 as the cooling target is preferably from 200 µm to 2 mm, and more preferably from 500 µm to 2 mm in terms of the cooling efficiency.

The average thickness of the metal layer 48 provided on the outer wall of the flow path configuration member 14 on the side opposite to the side where the cooling target is disposed is preferably from 1 µm to 2 mm, preferably from 200 µm to 2 mm, and more preferably from 500 µm to 2 mm in terms of magnetic field shielding.

The cooling structure according to the disclosure is effective for cooling electronic components such as a power module including a plurality of power semiconductors, and a capacitor, and a bus bar electrically joining these electronic components in a vehicle equipped with a motor such as a hybrid vehicle or an electric vehicle.

### Example

Hereinafter, magnetic field shielding performance and cooling performance of the metal layer are studied on the basis of an experimental example.

### Evaluation of Magnetic Field Shielding Performance

A PPS resin plate having a length of 120 mm, a width of 120 mm, and a thickness of 5 mm was prepared and used as a test piece 1.

A metal layer (a zinc layer) having an average thickness of 200 µm was formed on one surface of the test piece 1 by a thermal spraying method. This was used as a test piece 2.

An aluminum plate having a length of 120 mm, a width of 120 mm, and a thickness of 500 µm was used as a test piece 3.

For the test piece 1, the test piece 2, and the test piece 3, the magnetic field shielding performance was evaluated by an apparatus for evaluating a magnetic field shielding effect in a KEC method (from 500 Hz to 1 GHz) described below.

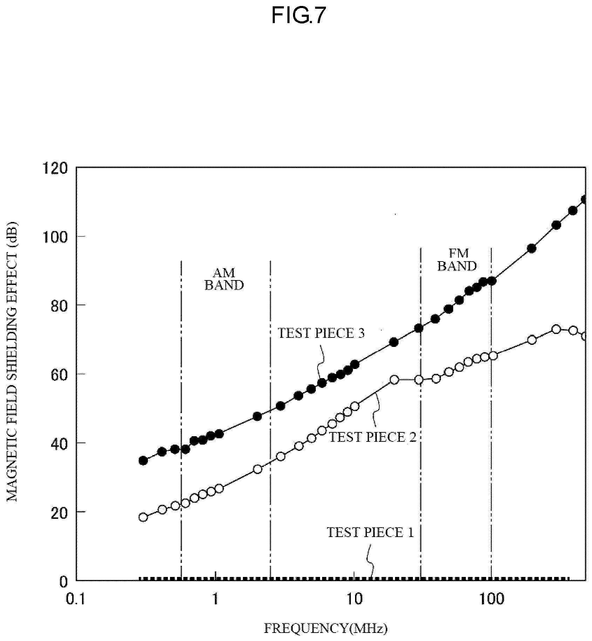

The obtained results are shown in Fig. 7. As is clear from Fig. 7, it can be seen that the test piece 2 and the test piece 3 show a more excellent magnetic field shielding effect than the test piece 1.

### Evaluation of Cooling Performance

A channel model 1 having a rectangular cross section with an outer diameter of 30 mm (width) × 15 mm (height), an inner diameter of 25 mm (width) × 10 mm (height), and a length of 110 mm was formed with use of a PPS resin. A metal layer 48 (a zinc layer) having an average thickness of 200 µm was formed on an upper surface of an outer wall of 110 mm × 30 mm of the channel model 1 by the thermal spraying method. This was defined as a channel model 2.

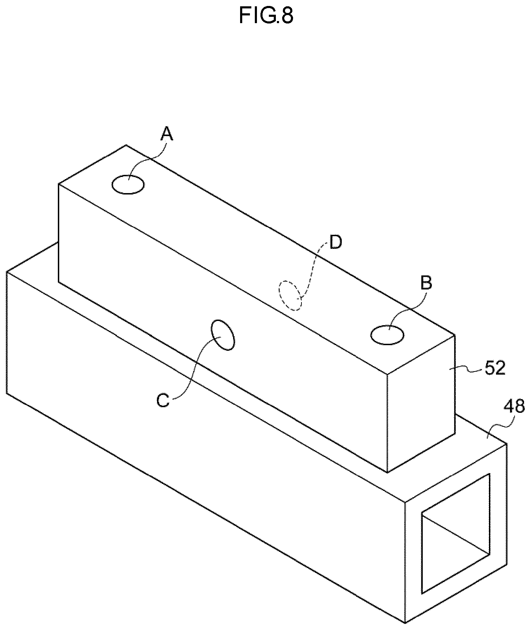

On each of the outer wall of 110 mm × 30 mm of the channel model 1 and the surface on which the metal layer 48 of the water channel model 2 was formed, an iron block 52 having a size of 95 mm × 25 mm × 15 mm and heated to 100°C was disposed as shown in Fig. 8, and water at 20°C was circulated in each channel model at a flow rate of 8 L/min.

Temperature changes at a total of four points A to D shown in Fig. 8 were measured with a high-performance recorder GR-3500 manufactured by KEYENCE CORPORATION immediately after the iron block 52 was disposed. As a result, the temperature at each measurement point 10 minutes after the iron block 52 was disposed was as shown in Table 1 below, and it became clear that the metal layer 48 was effective for cooling the cooling target.

**[Table 1]**

| | | Temperature after 10 minutes |
|---|---|---|
| Channel Model 1 | A | 69.2 °C |
| | B | 69.3 °C |
| | C | 68.7 °C |
| | D | 67.4 °C |
| Channel Model 2 | A | 38.9 °C |
| | B | 40.2 °C |
| | C | 39.0 °C |
| | D | 38.4 °C |

### REFERENCE SIGNS LIST

- 10, 11, 38, 44: Cooling structure
- 12: Flow path
- 14: Flow path configuration member
- 16: Upper inner wall
- 18: Lower inner wall
- 20: Side inner wall
- 22: Side inner wall
- 24: Cooling fin
- 26: Bus bar
- 28: Bolt
- 30: Nut
- 32: Nut body
- 34, 42: Heat diffuser
- 36: recess
- 40: inner wall
- 46: Power semiconductor
- 48: Metal layer
- 50: Region where the metal layer 48 is not provided
- 52: Iron block

## Claims

1. A cooling structure, comprising:
a flow path configuration member (14) made of resin and forming a flow path (12) through which a refrigerant flows; and
a cooling fin (24) extending from an inner wall (16) of the flow path (12) toward an inside of the flow path (12), having a distal end that is in contact with the inner wall (16), and having a surface made of resin,
**characterized by**
further comprising a heat diffuser (34) disposed at a root of the cooling fin (24) and a nut body (32) connected to the heat diffuser (34).

2. The cooling structure according to claim 1, wherein:
the cooling fin (24) is provided in a region in which an inner wall of the flow path (12) has a substantially rectangular shape when a cross section of the flow path (12) orthogonal to a direction in which the refrigerant flows is observed, and
the cooling fin (24) extends from one inner wall toward another inner wall of a pair of opposing inner walls (16, 18) of the inner wall having a substantially rectangular shape, and is in contact with the other inner wall (16, 18).

3. The cooling structure according to claim 1 or 2, wherein:
the flow path (12) is provided with a concave recess (36) at a portion of the inner wall of the flow path (12) in contact with the distal end of the cooling fin (24), and
the distal end of the cooling fin (24) is fitted in the concave recess (36).

4. The cooling structure according to any one of claims 1 to 3, wherein, when a portion of the flow path (12) in which the cooling fin (24) is provided is observed from the direction in which the refrigerant flows, an area of the cooling fin (24) accounts for 30% or more of an area of the flow path (12).

5. The cooling structure according to any one of claims 1 to 4, comprising a cooling target (26) disposed at a root of the cooling fin (24).

6. The cooling structure according to any one of claims 1 to 5, comprising a plurality of cooling fins (24) extending in directions substantially parallel to each other.

7. The cooling structure according to any one of claims 1 to 6, wherein the flow path configuration member (14) has an outer wall that is at least partially provided with a metal layer (48).

## Patentansprüche

1. Kühlstruktur, umfassend:
ein Strömungspfad-Konfigurationselement (14), das aus Harz hergestellt ist und einen Strömungspfad (12) bildet, durch den ein Kältemittel fließt; und
eine Kühlrippe (24), die sich von einer Innenwand (16) des Strömungspfads (12) zu einem Inneren des Strömungspfads (12) erstreckt, die ein distales Ende aufweist, das mit der Innenwand (16) in Berührung ist, und eine Oberfläche aufweist, die aus Harz hergestellt ist,
**dadurch gekennzeichnet, dass** sie
weiter einen Wärmeverteiler (34), der an einem Ansatz der Kühlrippe (24) angeordnet ist, und einen Schraubenmutterkörper (32), der mit dem Wärmeverteiler (34) verbunden ist, umfasst.

2. Kühlstruktur nach Anspruch 1, wobei:
die Kühlrippe (24) in einem Bereich bereitgestellt ist, in dem eine Innenwand des Strömungspfads (12) eine im Wesentlichen rechteckige Form aufweist, wenn ein Querschnitt des Strömungspfads (12) orthogonal zu einer Richtung, in der das Kühlmittel fließt, betrachtet wird, und
sich die Kühlrippe (24) von einer Innenwand zu einer anderen Innenwand eines Paars gegenüberliegender Innenwände (16, 18) der Innenwand erstreckt, die eine im Wesentlichen rechteckige Form aufweist und mit der anderen Innenwand (16, 18) in Berührung ist.

3. Kühlstruktur nach Anspruch 1 oder 2, wobei:
der Strömungspfad (12) mit einer konkaven Aussparung (36) an einem Abschnitt der Innenwand des Strömungspfads (12) in Berührung mit dem distalen Ende der Kühlrippe (24) bereitgestellt ist, und
das distale Ende der Kühlrippe (24) in die konkave Aussparung (36) eingepasst ist.

4. Kühlstruktur nach einem der Ansprüche 1 bis 3, wobei, wenn ein Abschnitt des Strömungspfads (12), in dem die Kühlrippe (24) bereitgestellt ist, von der Richtung betrachtet wird, in der das Kältemittel fließt, eine Fläche der Kühlrippe (24) 30 % oder mehr der Fläche des Strömungspfads (12) ausmacht.

5. Kühlstruktur nach einem der Ansprüche 1 bis 4, umfassend ein Kühlziel (26), das an einem Ansatz der Kühlrippe (24) angeordnet ist.

6. Kühlstruktur nach einem der Ansprüche 1 bis 5, umfassend eine Vielzahl von Kühlrippen (24), die sich in Richtungen erstrecken, die zueinander im Wesentlichen parallel sind.

7. Kühlstruktur nach einem der Ansprüche 1 bis 6, wobei das Strömungspfad-Konfigurationselement (14) eine Außenwand aufweist, die mindestens teilweise mit einer Metallschicht (48) bereitgestellt ist.

## Revendications

1. Structure de refroidissement, comprenant :
un élément de configuration de voie d'écoulement (14) fabriqué en résine et formant une voie d'écoulement (12) à travers laquelle un fluide frigorigène circule ; et
une ailette de refroidissement (24) s'étendant à partir d'une paroi intérieure (16) de la voie d'écoulement (12) vers un intérieur de la voie d'écoulement (12), présentant une extrémité distale qui est en contact avec la paroi intérieure (16), et présentant une surface fabriquée en résine,
**caractérisée en ce qu'**elle
comprend en outre un diffuseur de chaleur (34) disposé au niveau d'une racine de l'ailette de refroidissement (24) et un corps d'écrou (32) relié au diffuseur de chaleur (34).

2. Structure de refroidissement selon la revendication 1, dans laquelle :
l'ailette de refroidissement (24) est fournie dans une région dans laquelle une paroi intérieure de la voie d'écoulement (12) présente une forme substantiellement rectangulaire lorsqu'une section transversale de la voie d'écoulement (12) orthogonale à une direction dans laquelle le fluide frigorigène circule est observée, et
l'ailette de refroidissement (24) s'étend à partir d'une paroi intérieure vers une autre paroi intérieure d'une paire de parois intérieures opposées (16, 18) de la paroi intérieure présentant une forme substantiellement rectangulaire, et est en contact avec l'autre paroi intérieure (16, 18).

3. Structure de refroidissement selon la revendication 1 ou 2, dans laquelle :
la voie d'écoulement (12) est fournie avec un évidement concave (36) au niveau d'une partie de la paroi intérieure de la voie d'écoulement (12) en contact avec l'extrémité distale de l'ailette de refroidissement (24), et
l'extrémité distale de l'ailette de refroidissement (24) est installée dans l'évidement concave (36).

4. Structure de refroidissement selon l'une quelconque des revendications 1 à 3, dans laquelle, lorsqu'une partie de la voie d'écoulement (12) dans laquelle l'ailette de refroidissement (24) est fournie est observée à partir de la direction dans laquelle le fluide frigorigène circule, une zone de l'ailette de refroidissement (24) représente 30 % ou plus d'une zone de la voie d'écoulement (12).

5. Structure de refroidissement selon l'une quelconque des revendications 1 à 4, comprenant une cible de refroidissement (26) disposée au niveau d'une racine de l'ailette de refroidissement (24).

6. Structure de refroidissement selon l'une quelconque des revendications 1 à 5, comprenant une pluralité d'ailettes de refroidissement (24) s'étendant dans des directions substantiellement parallèles les unes aux autres.

7. Structure de refroidissement selon l'une quelconque des revendications 1 à 6, dans laquelle l'élément de configuration de voie d'écoulement (14) présente une paroi extérieure qui est au moins partiellement fournie avec une couche de métal (48).
